# EUROPEAN PATENT APPLICATION

(11) **EP 4 207 279 A1**
(43) Date of publication of application: **05.07.2023**
(21) Application number: 22217330.4
(22) Date of filing: 30.12.2022
(51) Int. Cl.: H01L 25/075, H01L 33/62

(54) **LED CHIP ASSEMBLY, LED DISPLAY APPARATUS AND PROCESSING METHOD OF LED CHIP ASSEMBLY**

(30) Priority: 31.12.2021 CN 202111676777
(71) Applicant: Leyard Optoelectronic Co., Ltd, Beijing 100091 (CN)
(72) Inventor: LU, Changjun, Beijing Haidian District, 100091 (CN); MA, Li, Beijing Haidian District, 100091 (CN)
(74) Representative: V.O.

(57) **Abstract**

The invention provides an LED chip assembly, an LED display apparatus and a processing method of the LED chip assembly. Herein, the LED chip assembly includes: a substrate layer; an LED light-emitting unit arranged in the substrate layer, the LED light-emitting unit including an LED chip; a transparent support layer arranged on a front side of the substrate layer and covering a light-emitting surface of the LED chip; a first insulating layer arranged on a back side of the substrate layer, a first circuit connected with a first electrode of the LED chip and a second circuit connected with a second electrode of the LED chip being arranged in the first insulating layer; and a second insulating layer arranged on a back side of the first insulating layer, a first conductive part in conductive connection with the first circuit and a second conductive part in conductive connection with the second circuit being arranged in the second insulating layer, and the first conductive part and the second conductive part being exposed from a back surface of the second insulating layer. A technical solution of the application effectively solves a problem that a line width and a line spacing of a preset line on a circuit board in a related art cannot meet connection requirements with an LED chip.

## Description

### Cross-Reference to Related Application

The present invention claims the priority to Chinese Patent Application No. 202111676777.6, filed to the Chinese Patent Office on December 31, 2021 and entitled "LED Chip Assembly, LED Display Apparatus and Processing Method of LED Chip Assembly", which is incorporated in its entirety herein by reference.

### Technical Field

The invention relates to a technical field of Light Emitting Diode (LED) display, in particular to an LED chip assembly, an LED display apparatus and a processing method of the LED chip assembly.

### Background

An LED lamp in a related art includes: a substrate or a support frame, an LED chip, a bonding wire and packaging glue. Firstly, the LED chip is die-bonded on the substrate or the support frame, and positive and negative electrodes of the LED chip are led out through the substrate or the support frame.

After a size of the LED chip is reduced, a line width and a line spacing of the substrate or the support frame cannot meet connection requirements with the LED chip. Generally, such requirements are met by replacing the substrate a higher-precision, but the substrate with the higher-precision is usually expensive. At present, a line is preset on a circuit board first, and then the LED chip is connected to the preset line with an adhesive. However, a line width and a line spacing of the preset line can hardly meet a requirement of LED die bonding with less than 20µm, which leads to poor connection effect and poor contact.

### Summary

The invention mainly aims to provide an LED chip assembly, an LED display apparatus and a processing method of the LED chip assembly, so as to solve a problem that a line width and a line spacing of a preset line on a circuit board in a related art cannot meet connection requirements with an LED chip.

In order to achieve above purpose, according to an aspect of the invention, an LED chip assembly is provided, including a substrate layer; an LED light-emitting unit arranged in the substrate layer, the LED light-emitting unit including an LED chip, a light-emitting surface of the LED chip being exposed from a front surface of the substrate layer, a first electrode and a second electrode of the LED chip being exposed from a back surface of the substrate layer; a transparent support layer arranged on a front side of the substrate layer and covering the light-emitting surface of the LED chip; a first insulating layer arranged on a back side of the substrate layer, a first circuit connected with the first electrode of the LED chip and a second circuit connected with the second electrode of the LED chip being arranged in the first insulating layer; and a second insulating layer arranged on a back side of the first insulating layer, a first conductive part in conductive connection with the first circuit and a second conductive part in conductive connection with the second circuit being arranged in the second insulating layer, and the first conductive part and the second conductive part being exposed from a back surface of the second insulating layer.

In some embodiments, N LED light-emitting units are provided, each of the LED light-emitting units being provided with three LED chips, N being a natural number and N ≥ 1. 3N first circuits, 3N second circuits and 3N first conductive parts are provided, N second conductive parts being provided, first ends of the 3N first circuits being respectively connected with first electrodes of 3N LED chips in one-to-one correspondence, a second end of each first circuit being connected with one first conductive part, first ends of the 3N second circuits being respectively connected with second electrodes of the 3N LED chips in one-to-one correspondence, and second ends of three second circuits corresponding to a same LED light-emitting unit being merged and connected with one second conductive part.

In some embodiments, the second insulating layer is a rectangular structure. When N = 1, three first conductive parts and one second conductive part are respectively located at four corners of the rectangular structure.

In some embodiments, 2N LED light-emitting units are provided, each of the LED light-emitting units being provided with three LED chips, 2N LED light-emitting units being arranged in pairs, two first electrodes of two adjacent LED chips being located between two second electrodes in each pair of LED light-emitting units, N being a natural number and N ≥ 1. 6N first circuits and 6N second circuits are provided, 3N first conductive parts being provided, two second conductive parts being provided, first ends of the 6N first circuits being respectively connected with first electrodes of 6N LED chips in one-to-one correspondence, second ends of two adjacent first circuits being merged and connected with one first conductive part, first ends of the 6N second circuits being respectively connected with second electrodes of the 6N LED chips in one-to-one correspondence, and second ends of the second circuits of the LED light-emitting units located in a same column being merged and connected with one second conductive part.

In some embodiments, the transparent support layer is a functional film, and the functional film is one or more of a polarizing film, an anti-glare film and a high-transmittance film. Herein, a light transmittance of the high-transmittance film is between 85% and 97%.

In some embodiment, the LED chip assembly further includes an adhesive layer connected between the functional film and the substrate layer.

In some embodiment, the first insulating layer is provided with a first notch for accommodating the first circuit and a second notch for accommodating the second circuit. The second insulating layer is provided with a third notch for accommodating the first conductive part and a fourth notch for accommodating the second conductive part.

In some embodiment, a thickness of the substrate layer is less than or equal to a thickness of the LED chip.

According to another aspect of the invention, a processing method of the LED chip assembly is provided, for processing the LED chip assembly. The processing method includes following steps: obtaining the transparent support layer; fixing the LED light-emitting unit to the transparent support layer and enabling the light-emitting surface of the LED chip of the LED light-emitting unit to face the transparent support layer; arranging the substrate layer around the LED light-emitting unit, and exposing the first electrode and the second electrode of the LED chip from a surface, away from the transparent support layer, of the substrate layer; covering the first insulating layer on the surface, away from the transparent support layer, of the substrate layer, and arranging the first circuit connected with the first electrode and the second circuit connected with the second electrode in the first insulating layer, wherein the first circuit and the second circuit both expose from a surface, away from the substrate layer, of the first insulating layer; and covering the second insulating layer on the surface, away from the substrate layer, of the first insulating layer, and arranging the first conductive part connected with the first electrode and the second conductive part connected with the second circuit in the second insulating layer, wherein the first conductive part and the second conductive part both expose from a surface, away from the first insulating layer, of the second insulating layer.

In some embodiment, after a step of obtaining the transparent support layer, the processing method further includes: covering a surface of the transparent support layer with an adhesive layer.

In some embodiment, a step of fixing the LED light-emitting unit to the transparent support layer and enabling the light-emitting surface of the LED chip of the LED light-emitting unit to face the transparent support layer includes: stacking a temporary substrate provided with the LED light-emitting unit together with the transparent support layer to fix the LED light-emitting unit to a surface, facing the temporary substrate, of the transparent support layer, and removing the temporary substrate.

According to another aspect of the invention, an LED display apparatus is provided, including one or more LED chip assemblies. The LED chip assembly is the above LED chip assembly.

By applying a technical solution of the invention, the LED chip assembly includes: the substrate layer, the LED light-emitting unit, the transparent support layer, the first insulating layer and the second insulating layer. The LED light-emitting unit is arranged in the substrate layer. The LED light-emitting unit includes the LED chip. The light-emitting surface of the LED chip is exposed from the front surface of the substrate layer, and the first electrode and the second electrode of the LED chip are exposed from the back surface of the substrate layer. The transparent support layer is arranged on the front side of the substrate layer and covers the light-emitting surface of the LED chip. The transparent support layer supports the substrate layer and the LED light-emitting unit, thus facilitating connection and fixation. The first insulating layer is arranged on the back side of the substrate layer, and the first circuit connected with the first electrode of the LED chip and the second circuit connected with the second electrode of the LED chip are arranged in the first insulating layer. The second insulating layer is arranged on the back side of the first insulating layer, the first conductive part in conductive connection with the first electrode and the second conductive part in conductive connection with the second electrode are arranged in the second insulating layer, and the first conductive part and the second conductive part are exposed from the back surface of the second insulating layer. Thus, the first circuit connected between the first conductive part and the first electrode and the second circuit connected between the second conductive part and the second electrode are integrated inside the LED chip assembly, and the first insulating layer isolates the first circuit and the second circuit to prevent short circuit, and the second insulating layer isolates not only the first conductive part and the second conductive part, but also isolates the first conductive part and the second circuit and isolates the second conductive part and the first circuit so as to prevent short circuit. Thus, the first conductive part, the second conductive part, the first circuit and the second circuit are integrated in the LED chip assembly, without using a circuit board with a preset line in the related art, which meets the connection requirements with the LED chip, and facilitates achieving packaging and mounting requirements of smaller LED chips, and be available to use requirements of smaller LED chips and smaller LED lamp beads. Therefore, the technical solution of the application solves the problem that the line width and the line spacing of the preset line on the circuit board in the related art cannot meet the connection requirements with the LED chip.

### Brief Description of the Drawings

The drawings consisting of a part of the invention are used for further understanding of the present invention. The schematic embodiments and description thereof are used for explaining the invention and do not limit the invention improperly. In the drawings,
Fig. 1 illustrates a schematic longitudinal sectional view of embodiment I of an LED display assembly according to the present invention.
Fig. 2 illustrates a schematic plan view of an LED light-emitting unit of the LED display assembly of Fig. 1 being located on a transparent support layer.
Fig. 3 illustrates a schematic plan view of a first insulating layer of the LED display assembly of Fig. 1.
Fig. 4 illustrates a schematic plan view of a second insulating layer of the LED display assembly of Fig. 1.
Fig. 5 illustrates a partial cross-sectional schematic diagram of the second insulating layer of the LED display assembly of Fig. 4.
Fig. 6 illustrates a schematic longitudinal sectional view of two LED light-emitting units being located on a transparent support layer according to embodiment II of the LED display assembly of the present invention.
Fig. 7 illustrates a schematic plan view of two LED light-emitting units of the LED display assembly of Fig. 6 being located on the transparent support layer.
Fig. 8 illustrates a schematic plan view of a first insulating layer of the LED display assembly of Fig. 6.
Fig. 9 illustrates a schematic plan view of a second insulating layer of the LED display assembly of Fig. 6.
Fig. 10 illustrates a schematic plan view of two LED light-emitting units being located on a transparent support layer according to embodiment III of the LED display assembly of the present invention.
Fig. 11 illustrates a schematic plan view of a first insulating layer of the LED display assembly of Fig. 10.
Fig. 12 illustrates a schematic plan view of a second insulating layer of the LED display assembly of Fig. 10.
Fig. 13 illustrates a schematic plan view of four LED light-emitting units being located on a transparent support layer according to embodiment IV of the LED display assembly of the present invention.
Fig. 14 illustrates a schematic plan view of a first insulating layer of the LED display assembly of Fig. 13.
Fig. 15 illustrates a schematic plan view of a second insulating layer of the LED display assembly of Fig. 13.

Herein, the above drawings include following reference numbers:
10. Substrate layer; 20. LED chip; 21. First electrode; 22. Second electrode; 23. Light-emitting surface; 30. Transparent support layer; 41. First insulating layer; 42. Second insulating layer; 51. First circuit; 52. Second circuit; 61. First conductive part; 62. Second conductive part; and 70. Adhesive layer.

### Detailed Description of the Embodiments

The technical solutions in the embodiments of the invention will be clearly and completely described below in combination with the drawings in the embodiments of the invention. It is apparent that the described embodiments are not all embodiments but part of embodiments of the invention. In fact, the description of at least one exemplary embodiment below is merely illustrative, and will not be taken as any limitation to the invention and its application or use. All other embodiments obtained by those of ordinary skill in the art on the basis of the embodiments in the invention without creative work shall fall within the scope of protection of the invention.

It should be noted that the terms used here are only for describing specific implementation modes, and are not intended to limit the exemplary implementation modes according to the application. As used herein, the singular form is also intended to include the plural form unless the context clearly indicates otherwise. In addition, it should also be understood that when the terms "comprising" and/or "including" are used in this specification, same indicate the presence of features, steps, operations, devices, components and/or combinations thereof.

Unless otherwise specified, relative arrangements of parts and steps, digital expressions and values elaborated in these embodiments will not limit the scope of the invention. Meanwhile, it should be understood, to facilitate the description, that the sizes of all parts shown in the drawings are not drawn according to an actual proportionate relationship. The technologies, the methods and the equipment known by those of ordinary skill in the art may not be elaborated. However, where appropriate, the technologies, the methods and the equipment should be deemed to be part of the authorized specification. In all examples shown and discussed here, any specific values should be merely explained to be exemplary rather than taken as a limitation. Therefore, other examples of the exemplary embodiments may have different values. It should be noted that the similar reference numbers and letters indicate the similar items in the drawings below, so there is no need to further discuss it in subsequent drawings once an item is defined in one drawing.

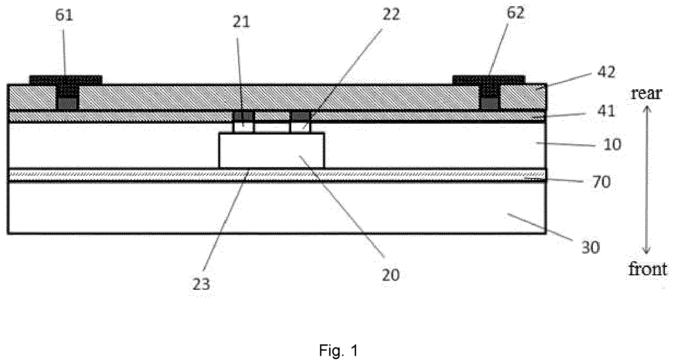

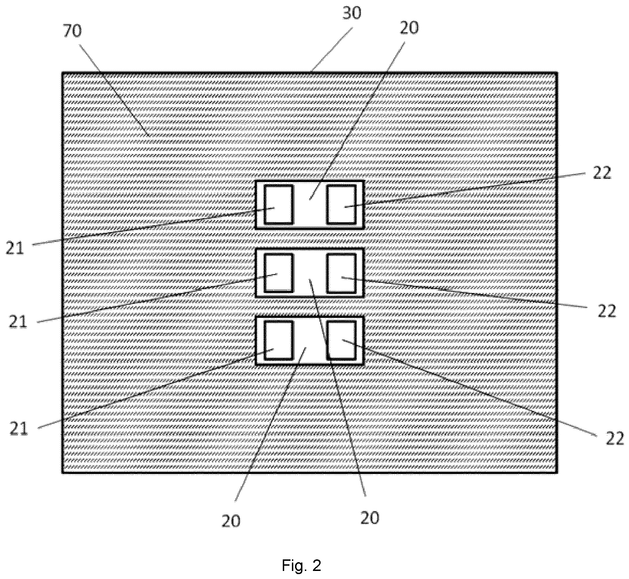

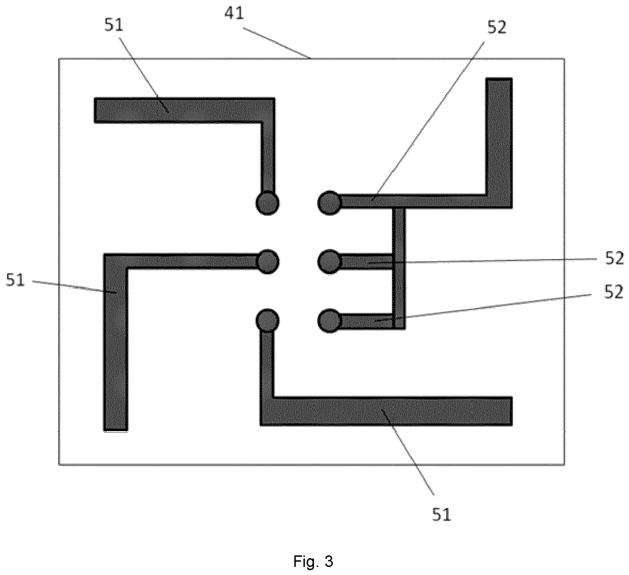

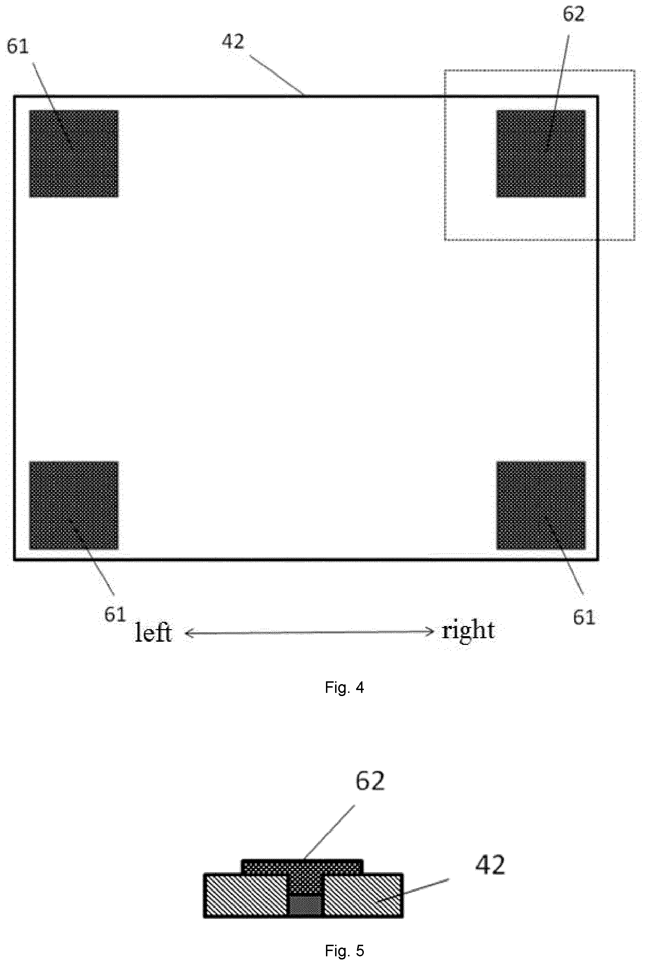

As shown in Figs. 1-5, an LED chip assembly in embodiment I includes: a substrate layer 10, an LED light-emitting unit, a transparent support layer 30, a first insulating layer 41 and a second insulating layer 42. The LED light-emitting unit is arranged in the substrate layer 10. The LED light-emitting unit includes an LED chip 20. A light-emitting surface 23 of the LED chip 20 is exposed from a front surface of the substrate layer 10, and a first electrode 21 and a second electrode 22 of the LED chip 20 are exposed from a back surface of the substrate layer 10. The transparent support layer 30 is arranged on a front side of the substrate layer 10 and covers the light-emitting surface 23 of the LED chip 20. The first insulating layer 41 is arranged on a back side of the substrate layer 10, and a first circuit 51 connected with the first electrode 21 of the LED chip 20 and a second circuit 52 connected with the second electrode 22 of the LED chip 20 are arranged in the first insulating layer 41. The second insulating layer 42 is arranged on a back side of the first insulating layer 41, a first conductive part 61 in conductive connection with the first circuit 51 and a second conductive part 62 in conductive connection with the second circuit 52 are arranged in the second insulating layer 42, and the first conductive part 61 and the second conductive part 62 are exposed from a back surface of the second insulating layer 42.

By applying a technical solution of embodiment I, the transparent support layer 30 is arranged on the front side of the substrate layer 10 and covers the light-emitting surface 23 of the LED chip 20. The transparent support layer 30 supports the substrate layer 10 and the LED light-emitting unit during processing, thus facilitating connection and fixation. The first insulating layer 41 is arranged on the back side of the substrate layer 10, and the first circuit 51 connected with the first electrode 21 of the LED chip 20 and the second circuit 52 connected with the second electrode 22 of the LED chip 20 are arranged in the first insulating layer 41. The second insulating layer 42 is arranged on the back side of the first insulating layer 41, the first conductive part 61 in conductive connection with the first electrode 21 and the second conductive part 62 in conductive connection with the second electrode 22 are arranged in the second insulating layer 42, and the first conductive part 61 and the second conductive part 62 are exposed from the back surface of the second insulating layer 42. Thus, the first circuit 51 connected between the first conductive part 61 and the first electrode 21 and the second circuit 52 connected between the second conductive part 62 and the second electrode 22 are integrated inside the LED chip assembly, and the first insulating layer 41 isolates the first circuit 51 and the second circuit 52 to prevent short circuit. Moreover, the second insulating layer 42 isolates not only the first conductive part 61 and the second conductive part 62, but also isolates the first conductive part 61 and the second circuit 52 and isolates the second conductive part 62 and the first circuit 51 so as to prevent short circuit. Thus, according to the technical solution of the embodiment, the first conductive part 61, the second conductive part 62, the first circuit 51 and the second circuit 52 are integrated in the LED chip assembly, without using a circuit board with a preset line in the related art, which meets connection requirements with the LED chip 20, and facilitates achieving packaging and mounting requirements of smaller LED chips 20, and be available to use requirements of smaller LED chips 20 and smaller LED lamp beads. Therefore, the technical solution of embodiment I solves a problem that a line width and a line spacing of the preset line on the circuit board in the related art cannot meet the connection requirements with the LED chip 20. It is to be noted that a polarity of the first electrode 21 is opposite to a polarity of the second electrode 22, and polarity of one of the first electrode 21 and the second electrode 22 is positive and the other is negative. The LED light-emitting unit is a pixel structure.

The substrate layer 10 of embodiment I is made of one or more materials of epoxy, silica gel and black ink, and carbon powder may also be added to epoxy and silica gel to improve a contrast of the LED chip assembly. The first insulating layer 41 and the second insulating layer 42 are both SiO₂ films or SiN films. The first circuit 51 and the second circuit 52 may be transparent conductive line layers formed of ITO, ZnO, silver nanowire or graphene, and may also be line layers formed of metal or alloy such as copper, gold or nickel. The first electrode 21, the second electrode 22, the first conductive part 61, and the second conductive part 62 may all be formed of an alloy of copper, nickel, and gold, and with a gold surface layer. Moreover, the LED light-emitting unit of the embodiment is first fixed to the transparent support layer 30, and then the first conductive part 61 and the second conductive part 62 are led out from the second insulating layer 42 by semiconductor deposition, photolithography and other processes, so that a precision is higher.

As shown in Figs. 1-5, in embodiment I, N = 1, one LED light-emitting unit is provided, and the LED light-emitting unit is provided with three LED chips 20. Three first circuits 51, three second circuits 52 and three first conductive parts 61 are provided, and one second conductive part 62 is provided. The three LED chips 20 are a red chip, a green chip and a blue chip.

Specifically, when the first electrode 21 is positive and the second electrode 22 is negative, first ends of the three first circuits 51 are respectively connected with positive electrodes of the three LED chips 20 in one-to-one correspondence, and a second end of each first circuit 51 is connected with one first conductive part 61. First ends of the three second circuits 52 are respectively connected with negative electrodes of the three LED chips 20 in one-to-one correspondence, and second ends of the three second circuits 52 are merged and connected with the second conductive part 62. The second ends of the three second circuits 52 are merged so that a common electrode is formed. Thus, the first circuits 51 and the second circuits 52 are conveniently connected and wired, and an arrangement of a plurality of LED chips 20 is more reasonable. When the first electrode 21 is negative and the second electrode 22 is positive, first ends of the three first circuits 51 are respectively connected with negative electrodes of the three LED chips 20 in one-to-one correspondence, and a second end of each first circuit 51 is connected with one first conductive part 61. First ends of the three second circuits 52 are respectively connected with positive electrodes of the three LED chips 20 in one-to-one correspondence, and second ends of the three second circuits 52 are merged and connected with the second conductive part 62. The second ends of the three second circuits 52 are merged so that a common electrode is formed. Thus, the first circuits 51 and the second circuits 52 are conveniently connected and wired, and an arrangement of the LED chips 20 is more reasonable.

As shown in Figs. 1-5, in embodiment I, in order to arrange the three first conductive parts 61 and the one second conductive part 62 on the second insulating layer 42 more reasonably, the second insulating layer 42 is a rectangular structure, and the three first conductive parts 61 and the one second conductive part 62 are located at four corners of the rectangular structure, respectively.

As shown in Figs. 1-5, in embodiment I, the transparent support layer 30 is a functional film, and the functional film is one or more of a polarizing film, an anti-glare film and a high-transmittance film. Herein, a light transmittance of the high-transmittance film is between 85% and 97%, and the light transmittance is preferably 85% or 89% or 93% or 97%. The functional film realizes a special luminous effect of the LED chip assembly. When the functional film is a polarizing film, an LED chip assembly with polarized light is realized, and arranging LED chip assemblies with different polarization directions in a spaced array realizes an LED display screen with a 3D function. When the functional film is an anti-glare film, an LED chip assembly with low reflectivity is realized. Herein, a reflectivity SCI is between 3% and 8%, and the reflectivity SCI is preferably 3% or 5% or 8%. When the functional film is a high-transmittance film, an LED chip assembly with high light transmittance is realized. A thickness of the functional film is greater than or equal to 20 µ m, which brings convenience for arranging a single-layer film or a composite film, and facilitates improving the luminous effect.

Specifically, when the functional film is a polarizing film, for example, a left polarizing film is used as a bearing film of one LED light-emitting unit to prepare a No.1 LED light-emitting unit, and a right polarizing film is used as a bearing film of another LED light-emitting unit to prepare a No.2 LED light-emitting unit. When an LED display apparatus is prepared, the No.1 LED light-emitting unit and No.2 LED light-emitting unit are used as pixels in adjacent rows or columns respectively, so that an LED display screen with different polarization directions in adjacent columns or adjacent rows, that is, an LED display screen with a 3D effect, is realized.

As shown in Figs. 1-5, in order to facilitate bonding the substrate layer 10 to the functional film, the LED chip assembly further includes an adhesive layer 70 connected between the functional film and the substrate layer 10. The adhesive layer 70 is preferably transparent UV glue or thermosetting glue.

As shown in Figs. 1-5, the first insulating layer 41 is provided with a first notch for accommodating the first circuit 51 and a second notch for accommodating the second circuit 52. The positive electrodes of the three LED chips 20 of RGB are connected together through the first notch, and the other three negative electrodes of the LED chips 20 are independent from each other, and vice versa. The second insulating layer 42 is provided with a third notch for accommodating the first conductive part 61 and a fourth notch for accommodating the second conductive part 62. The first conductive part 61 connected with the first circuit 51 is led out from the back surface of the second insulating layer 42 through the third notch, and the second conductive part 62 connected with the second circuit 52 is led out from the back surface of the second insulating layer 42 through the fourth notch.

As shown in Figs. 1-5, in order to facilitate arranging the first insulating layer 41 on the back surface of the substrate layer 10, a thickness of the substrate layer 10 is less than or equal to a thickness of the LED chip 20.

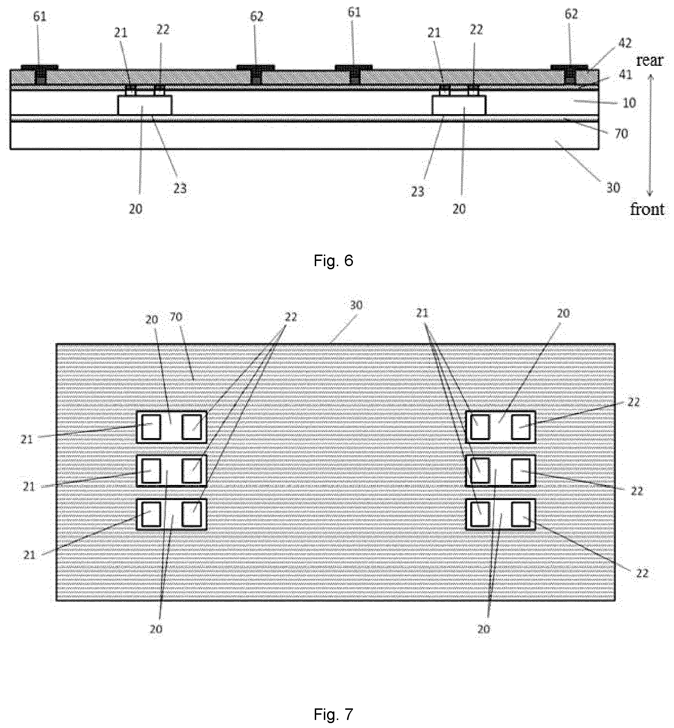

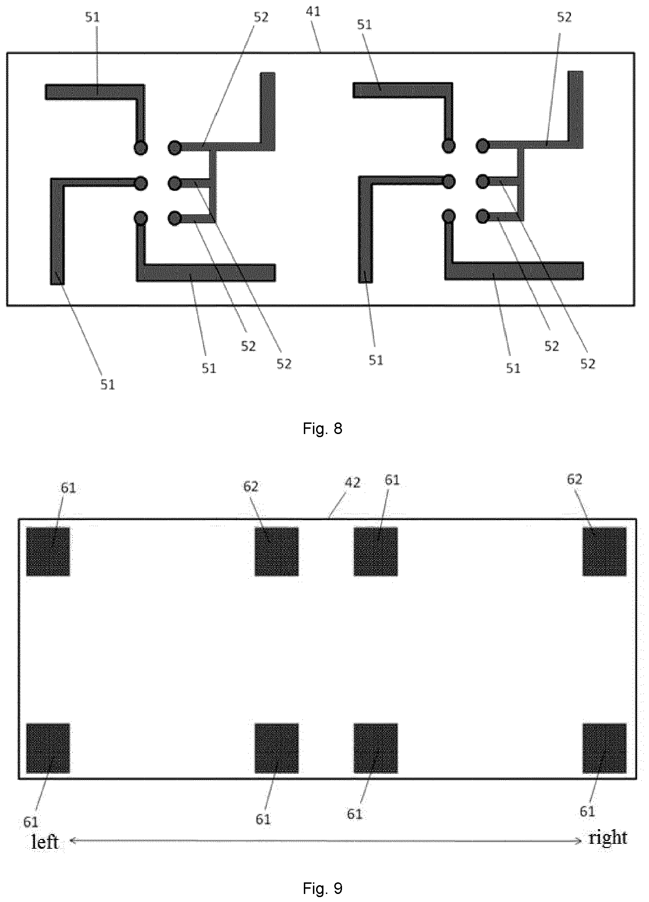

Embodiment II of the LED chip assembly of the present application is different from embodiment I of the LED chip assembly in a number of LED light-emitting units. As shown in Fig. 1 and Figs. 6-9, in embodiment II, N = 2, and two LED light-emitting units are provided. The two LED light-emitting units are arranged left and right, and each LED light-emitting unit is provided with three LED chips 20. Six first circuits 51, six second circuits 52 and six first conductive parts 61 are provided, and two second conductive parts 62 are provided. The three LED chips 20 of each LED light-emitting unit are a red chip, a green chip and a blue chip. Herein, a center distance of two red chips refers to a center distance of two LED light-emitting units. The first electrode 21 and the second electrode 22 of the red chip of a left LED light-emitting unit are arranged in a left-to-right direction in Fig. 6, and the first electrode 21 and the second electrode 22 of the red chip of a right LED light-emitting unit are also arranged in the left-to-right direction in Fig. 6. Similarly, arrangement of the first electrode 21 and the second electrode 22 of the green chips is the same as that of the red chips, and arrangement of the first electrode 21 and the second electrode 22 of the blue chips is the same as that of the red chips.

As shown in Fig. 1 and Figs. 6-9, when the first electrode 21 is positive and the second electrode 22 is negative, first ends of the six first circuits 51 are respectively connected with positive electrodes of six LED chips 20 in one-to-one correspondence, and a second end of each first circuit 51 is connected with one first conductive part 61. First ends of the six second circuits 52 are respectively connected with negative electrodes of the six LED chips 20 in one-to-one correspondence, second ends of three second circuits 52 of each LED light-emitting unit are merged and connected with one second conductive part 62, and the second ends of the three second circuits 52 of each LED light-emitting unit are merged so that a common electrode is formed. When the first electrode 21 is negative and the second electrode 22 is positive, first ends of the six first circuits 51 are respectively connected with negative electrodes of six LED chips 20 in one-to-one correspondence, and a second end of each first circuit 51 is connected with one first conductive part 61. First ends of the six second circuits 52 are respectively connected with positive electrodes of the six LED chips 20 in one-to-one correspondence, second ends of three second circuits 52 of each LED light-emitting unit are merged and connected with one second conductive part 62, and the second ends of the three second circuits 52 of each LED light-emitting unit are merged so that a common electrode is formed. Thus, the first circuit 51 and the second circuit 52 are conveniently connected and wired, and an arrangement of the LED chips 20 is more reasonable.

In embodiment II, the second insulating layer 42 is a rectangular structure, and the six first conductive parts 61 and the two second conductive parts 62 are located at four corners and a middle of the rectangular structure, respectively.

In an embodiment not shown in the figures, N LED light-emitting units are provided, wherein N is a natural number and N ≥ 3, and each LED light-emitting unit is provided with three LED chips 20. 3N first circuits 51, 3N second circuits 52 and 3N first conductive parts 61 are provided. N second conductive parts 62 are provided. First ends of the 3N first circuits 51 are respectively connected with first electrodes 21 of 3N LED chips 20 in one-to-one correspondence, and a second end of each first circuit 51 is connected with one first conductive part 61. First ends of the 3N second circuits 52 are respectively connected with second electrodes 22 of the 3N LED chips 20 in one-to-one correspondence, and second ends of three second circuits 52 of each LED light-emitting unit are merged and connected with one second conductive part 62. Herein, the second ends of the three second circuits 52 of each LED light-emitting unit are merged so that a common electrode is formed.

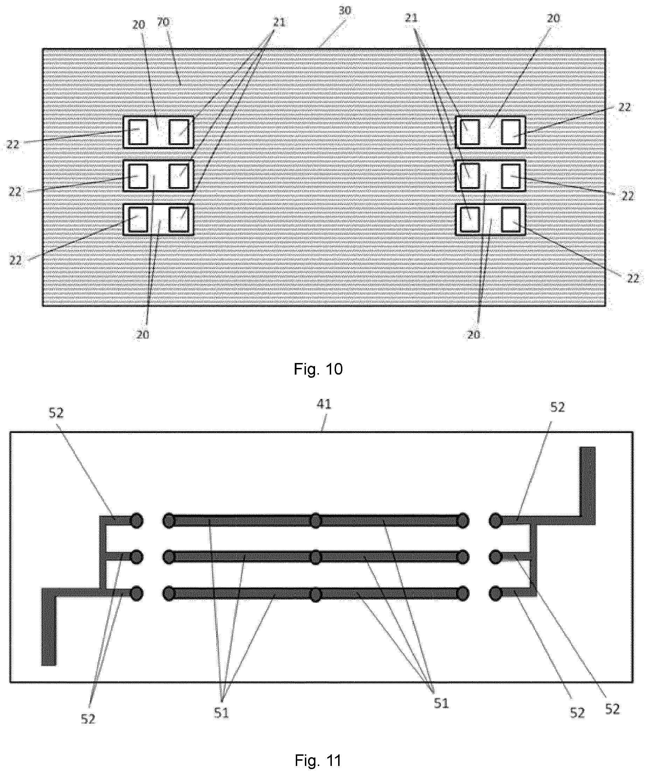

As shown in Fig. 1 and Figs. 10-12, embodiment III of the LED chip assembly of the present application is different from embodiment II of the LED chip assembly in an arrangement of the LED chips 20 of the two LED light-emitting units. In embodiment III, two LED light-emitting units are provided. Two LED light-emitting units are arranged left and right. Each LED light-emitting unit is provided with three LED chips 20. Two LED light-emitting units are arranged in pairs, and two first electrodes 21 of two adjacent LED chips 20 are located between two second electrodes 22. In embodiment III, the first electrodes 21 and the second electrodes 22 of the LED chips 20 of a left LED light-emitting unit are arranged in a right-to-left direction in Fig. 10. The first electrodes 21 and the second electrodes 22 of the LED chips 20 of a right LED light-emitting unit are arranged in a left-to-right direction in Fig. 10.

As shown in Fig. 1 and Figs. 10-12, the three LED chips 20 of each LED light-emitting unit are a red chip, a green chip and a blue chip, and six LED chips 20 include two red chips, two green chips and two blue chips. Herein, a center distance of two red chips refers to a center distance of two LED light-emitting units. Two first electrodes 21 are located between two second electrodes 22. Herein, the two second electrodes 22 are the second electrode 22 of the red chip of the left LED light-emitting unit and the second electrode 22 of the red chip of the right LED light-emitting unit, respectively and the two first electrodes 21 are the first electrode 21 of the red chip of the left LED light-emitting unit and the first electrode 21 of the red chip of the right LED light-emitting unit, respectively. Similarly, an arrangement of the first electrodes 21 and the second electrodes 22 of the green chips is the same as that of the red chips, and an arrangement of the first electrodes 21 and the second electrodes 22 of the green chips is the same as that of the red chips.

As shown in Fig. 1 and Figs. 10-12, six first circuits 51 and six second circuits 52 are provided. When the first electrode 21 is negative and the second electrode 22 is positive, three first conductive parts 61 and two second conductive parts 62 are provided, and first ends of the six first circuits 51 are respectively connected with first electrodes 21 of the six LED chips 20 in one-to-one correspondence. Second ends of two adjacent first circuits 51 are merged and connected with one first conductive part 61, first ends of the six second circuits 52 are respectively connected with second electrodes 22 of the six LED chips 20 in one-to-one correspondence, and second ends of three second circuits 52 of each LED light-emitting unit are merged and connected with one second conductive part 62. The second ends of two adjacent first circuits 51 are merged so that a common electrode is formed, and the second ends of the three second circuits 52 of each LED light-emitting unit are merged so that a common electrode is formed. Thus, the first circuit 51 and the second circuit 52 are conveniently connected and wired, and an arrangement of the LED chips 20 is more reasonable.

In embodiment III, the second insulating layer 42 is a rectangular structure, and the three first conductive parts 61 and the two second conductive parts 62 are located at three corners and a middle of the rectangular structure, respectively.

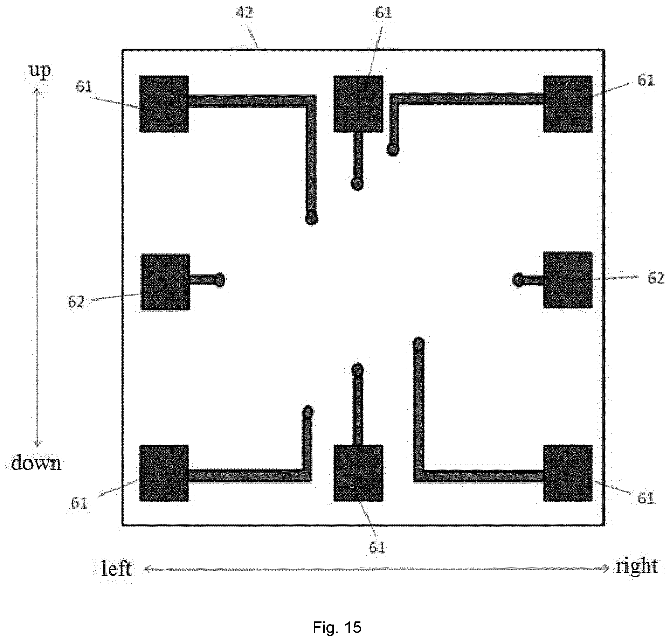

Embodiment IV of the LED chip assembly of the present application is different from embodiment III of the LED chip assembly in a number of LED light-emitting units. As shown in Fig. 1 and Figs. 13-15, in embodiment IV, four LED light-emitting units are provided. Two LED light-emitting units are arranged left and right to form a first group, another two LED light-emitting units are arranged left and right to form a second group, and the second group is located below the first group. Four LED light-emitting units are provided, and each LED light-emitting unit is provided with three LED chips 20. The four LED light-emitting units are arranged in pairs, and two first electrodes 21 of two adjacent LED chips 20 are located between two second electrodes 22 in each pair of LED light-emitting units. The three LED chips 20 of each LED light-emitting unit are a red chip, a green chip and a blue chip, and the twelve LED chips 20 include four red chips, four green chips and four blue chips. Herein, a center distance of each two red chips left and right refers to a center distance of two LED light-emitting units. Two first electrodes 21 are located between two second electrodes 22. Herein, the two second electrodes 22 are the second electrode 22 of the red chip of a left LED light-emitting unit and the second electrode 22 of the red chip of a right LED light-emitting unit, respectively and the two first electrodes 21 are the first electrode 21 of the red chip of the left LED light-emitting unit and the first electrode 21 of the red chip of the right LED light-emitting unit, respectively. Similarly, an arrangement of the first electrodes 21 and the second electrodes 22 of the green chips is the same as that of the red chips, and an arrangement of the first electrodes 21 and the second electrodes 22 of the blue chips is the same as that of the red chips.

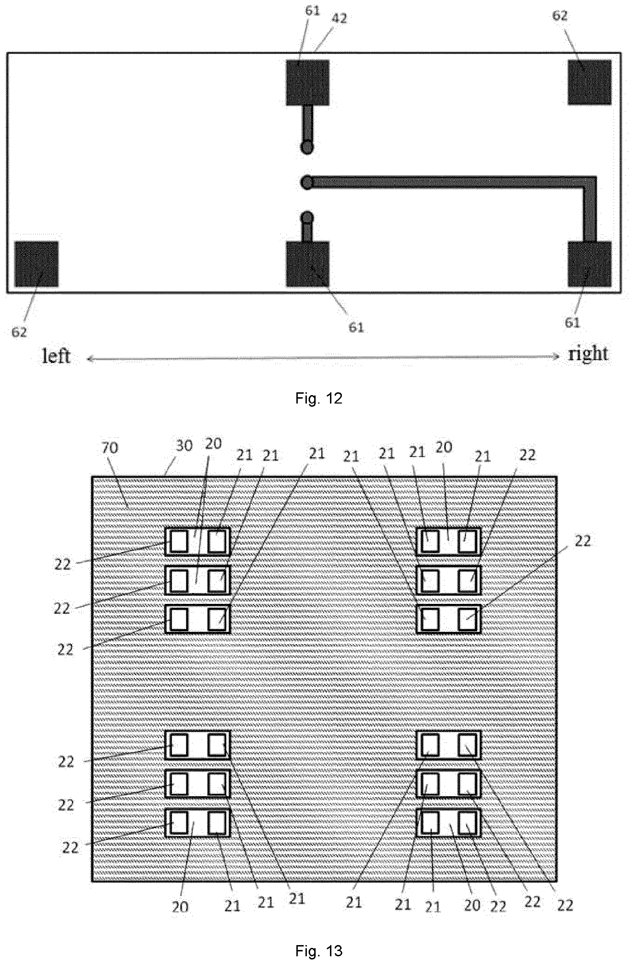

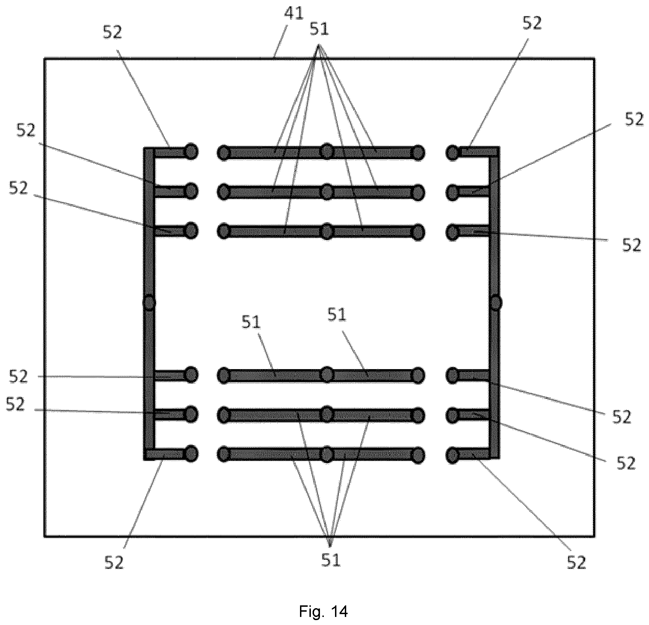

As shown in Fig. 1 and Figs. 13-15, twelve first circuits 51 and twelve second circuits 52 are provided, and six first conductive parts 61 and two second conductive parts 62 are provided. First ends of the twelve first circuits 51 are respectively connected with first electrodes 21 of the twelve LED chips 20 in one-to-one correspondence, and second ends of six first circuits 51 of two LED light-emitting units in each group are merged in pairs and connected with three first conductive parts 61 respectively. First ends of the twelve second circuits 52 are respectively connected with second electrodes 22 of the twelve LED chips 20 in one-to-one correspondence, and second ends of six second circuits 52 (six second circuits 52 located on a left side or six second circuits 52 located on a right side in Fig. 14) of the LED light-emitting units in a same column (arranged up and down in Fig. 13) are merged and connected with one second conductive part 62. Second ends of two first circuits 51 are merged so that a common electrode is formed, and the second ends of the six second circuits 52 are merged so that a common electrode is formed. Thus, the first circuit 51 and the second circuit 52 are conveniently connected and wired, and an arrangement of the LED chips 20 is more reasonable.

In embodiment IV, the second insulating layer 42 is a rectangular structure. The six first conductive parts 61 and the two second conductive parts 62 are located at four corners and a middle of the rectangular structure.

In an embodiment not shown in the figures, 2N LED light-emitting units are provided, wherein N ≥ 3. Each LED light-emitting unit is provided with three LED chips 20, 2N LED light-emitting units are arranged in pairs, and two first electrodes 21 of two adjacent LED chips 20 are located between two second electrodes 22 in each pair of LED light-emitting units. 6N first circuits 51 and 6N second circuits 52 are provided, and 3N first conductive parts 61 and two second conductive parts 62 are provided. First ends of the 6N first circuits 51 are respectively connected with first electrodes 21 of 6N LED chips 20 in one-to-one correspondence, second ends of two adjacent first circuits 51 in the 6N first circuits 51 are merged and connected with one first conductive part 61. First ends of the 6N second circuits 52 are respectively connected with second electrodes 22 of the 6N LED chips 20 in one-to-one correspondence, and second ends of 3N second circuits 52 of the LED light-emitting units located in the same column are merged and connected with one second conductive part 62. The second ends of the first circuits 51 are merged so that a common electrode is formed, and the second ends of the second circuits 52 are merged so that a common electrode is formed.

The application further provides an LED display apparatus. The LED display apparatus of the embodiment includes one or more LED chip assemblies. The LED chip assembly is the above LED chip assembly. As the LED chip assembly solves the problem that the line width and the line distance of the preset line on the circuit board in the related art cannot meet the connection requirements with the LED chip, the LED display apparatus including the LED chip assembly solves the same technical problem.

The application also provides a processing method of an LED chip assembly, for processing the LED chip assembly. As shown in Figs. 1-5, the processing method of the LED chip assembly includes following steps.
Obtaining the transparent support layer 30;
fixing the LED light-emitting unit to the transparent support layer 30 and enabling the light-emitting surface 23 of the LED chip 20 of the LED light-emitting unit to face the transparent support layer 30;
arranging the substrate layer 10 around the LED light-emitting unit, and exposing the first electrode 21 and the second electrode 22 of the LED chip 20 from a surface, away from the transparent support layer 30, of the substrate layer 10.
covering the first insulating layer 41 on the surface, away from the transparent support layer 30, of the substrate layer 10, and arranging the first circuit 51 connected with the first electrode 21 and the second circuit 52 connected with the second electrode 22 in the first insulating layer 41, wherein the first circuit 51 and the second circuit 52 both expose from a surface, away from the substrate layer 10, of the first insulating layer 41.
covering the second insulating layer 42 on the surface, away from the substrate layer 10, of the first insulating layer 41, and arranging the first conductive part 61 connected with the first electrode 21 and the second conductive part 62 connected with the second circuit 52 in the second insulating layer 42, are the first conductive part 61 and the second conductive part 62 both expose from a surface, away from the first insulating layer 41, of the second insulating layer 42.

Thus, the first circuit 51 connected between the first conductive part 61 and the first electrode 21 and the second circuit 52 connected between the second conductive part 62 and the second electrode 22 are integrated inside the LED chip assembly, and the first insulating layer 41 isolates the first circuit 51 and the second circuit 52 to prevent short circuit, and the second insulating layer 42 isolates not only the first conductive part 61 and the second conductive part 62, but also isolates the first conductive part 61 and the second circuit 52 and isolates the second conductive part 62 and the first circuit 51 so as to prevent short circuit. Thus, according to a technical solution of the embodiment, the first conductive part 61, the second conductive part 62, the first circuit 51 and the second circuit 52 are integrated in the LED chip assembly, without using the circuit board with the preset line in the related art, which meets the connection requirements with the LED chip 20, and facilitates achieving packaging and mounting requirements of smaller LED chips 20, and be available to use requirements of smaller LED chips 20 and smaller LED lamp beads. Therefore, the technical solution of the embodiment solve the problem that the line width and the line spacing of the preset line on the circuit board in the related art cannot meet the connection requirements with the LED chip 20.

As shown in Figs. 1-5, after a step of obtaining the transparent support layer 30, the processing method further includes: covering a surface of the transparent support layer 30 with the adhesive layer 70. Thus, the LED light-emitting unit is adhered to the transparent support layer 30 through the adhesive layer 70.

As shown in Figs. 1-5, a step of fixing the LED light-emitting unit to the transparent support layer 30 and enabling the light-emitting surface 23 of the LED chip 20 of the LED light-emitting unit to face the transparent support layer 30 includes: stacking a temporary substrate provided with the LED light-emitting unit together with the transparent support layer 30 to fix the LED light-emitting unit to a surface, facing the temporary substrate, of the transparent support layer 30, and removing the temporary substrate. An arrangement of the temporary substrate facilitates positioning of the LED light-emitting unit, so that the LED light-emitting unit is quickly and accurately fixed to the surface, facing the temporary substrate, of the transparent support layer 30.

In the embodiment, the processing method of the LED chip assembly includes following specific steps.
1. Take out a hard substrate, the substrate being made of a thermal shrinkage transparent material such as glass, quartzite or sapphire, and at least three of four corners of the substrate being etched with laser to form round, square or alignment marks with other shapes. Print a layer of UVdebonded adhesive on the substrate, and the substrate is used as a support plate for a subsequent process of the LED light emitting unit.
2. Adhered a functional film to the substrate, and print or spin coat an adhesive layer on the functional film.
3. Take out a temporary substrate is taken out. An LED light-emitting unit with LED chips 20 of RGB is arranged the temporary substrate, and a first electrode 21 and a second electrode 22 of the LED chips 20 face the temporary substrate, and the temporary substrate is also provided with alignment marks.
4. Stack the temporary substrate with the hard substrate and confirm positions of the alignment marks, and bond the LED chip 20 the functional film through an adhesive, and thermally cure the adhesive at a thermosetting temperature of 120 DEG C ~ 200 DEG C for 30 minutes ~ 2 hours.
5. Arrange a substrate layer 10 around the LED chip 20 by molding, dispensing, spraying, etc., and a thickness of the substrate layer 10 is less than or equal to a thickness of the LED chip 20.
6. Deposit an insulating film (namely a first insulating layer 41) on an upper surface of the substrate layer 10 and the LED chip 20 by adopting CVD process, and a thickness of the insulating film is preferably 20 nm ~ 1 µ m.
7. Arrange three first notches and three second notches on the first insulating layer 41 by photolithography. The first notches correspond to positive electrodes of the LED chip 20 and the second notches correspond to negative electrodes of the LED chip 20.
8. Deposit a metal layer on the first insulating layer 41, and form a first circuit 51 and a second circuit 52 by photolithography, etching or other processes.
9. Deposit a second insulating layer 42 on an upper surface of the first insulating layer 41 by adopting CVD process, and a thickness of the second insulating layer 42 is between 20 nm and 1 µ m.
10. Arrange three third notches and one fourth notch on the second insulating layer 42 by photolithography. The three third notches correspond to three independent first circuits 52, and the fourth notch corresponds to merged second circuits 52.
11. Deposit a metal layer on the second insulating layer 42, and form three first conductive parts 61 and a second conductive part 62 by photolithography, etching or other processes.
12. Cut the LED chip assembly according to a preset size, irradiate the LED display assembly from a side, far away from the second insulating layer 42, of the substrate with UV light to release an adhesion between the substrate and the functional film, thus obtaining a separated LED chip assembly.

In the description of the invention, it is to be understood that orientation or position relationships indicated by terms "front", "back", "upper", "lower", "left", "right", "transverse", "longitudinal", "vertical", "horizontal", "top", "bottom" and the like are orientation or position relationships shown in the drawings usually, are adopted not to indicate or imply that indicated devices or components must be in specific orientations or structured and operated in specific orientations but only to conveniently describe the invention and simplify descriptions and thus should not be understood as limits to the scope of protection of invention. The orientations "inner" and "outer" are the inside and the outside relative to an outline of each part.

For convenient description, spatially relativity terms such as "on", "above", "on the surface of", "on the top of" may be used herein to describe the spatial positional relationship of one device or one feature to other devices or features as shown in the drawings. It will be understood that the spatially relativity terms are intended to encompass different orientations used or operated in addition to the orientations of the devices described in the drawings. For example, if the device in the drawings is inverted, the device described as "on other devices or configurations" or "above other devices or configurations" will then be positioned "under other devices or configurations" or "below other devices or configurations." Thus, the exemplary term "above" may include both orientations of "above" and "below". The device may also be positioned in other different ways (rotated 90° or at other orientations) and the spatially relativity description used herein is interpreted accordingly.

In addition, it should be noted that terms "first", "second" and the like are used for limiting the parts, for facilitating distinguishing corresponding parts only. Unless otherwise stated, the above terms do not have special meanings, and accordingly should not be understood to limit the scope of protection of the invention.

The above are only the preferred embodiments of the invention and are not used to limit the invention. For those skilled in the art, there may be various changes and variations in the invention. Any modifications, equivalent replacements, improvements and the like made within the spirit and principle of the invention shall fall within the scope of protection of the invention.

## Claims

1. An LED chip assembly, comprising:
a substrate layer (10);
an LED light-emitting unit arranged in the substrate layer (10), the LED light-emitting unit comprising an LED chip (20), a light-emitting surface (23) of the LED chip (20) being exposed from a front surface of the substrate layer (10), a first electrode (21) and a second electrode (22) of the LED chip (20) being exposed from a back surface of the substrate layer (10);
a transparent support layer (30) arranged on a front side of the substrate layer (10) and covering the light-emitting surface (23) of the LED chip (20);
a first insulating layer (41) arranged on a back side of the substrate layer (10), a first circuit (51) connected with the first electrode (21) of the LED chip (20) and a second circuit (52) connected with the second electrode (22) of the LED chip (20) being arranged in the first insulating layer (41); and
a second insulating layer (42) arranged on a back side of the first insulating layer (41), a first conductive part (61) in conductive connection with the first circuit (51) and a second conductive part (62) in conductive connection with the second circuit (52) being arranged in the second insulating layer (42), and the first conductive part (61) and the second conductive part (62) being exposed from a back surface of the second insulating layer (42).

2. The LED chip assembly as claimed in claim 1, wherein
N LED light-emitting units are provided, each of the LED light-emitting units being provided with three LED chips (20), N being a natural number and N ≥ 1,
wherein 3N first circuits (51), 3N second circuits (52) and 3N first conductive parts (61) are provided, N second conductive parts (62) being provided, first ends of the 3N first circuits (51) being respectively connected with first electrodes (21) of 3N LED chips (20) in one-to-one correspondence, a second end of each first circuit (51) being connected with one first conductive part (61), first ends of the 3N second circuits (52) being respectively connected with second electrodes (22) of the 3N LED chips (20) in one-to-one correspondence, and second ends of three second circuits (52) corresponding to a same LED light-emitting unit being merged and connected with one second conductive part (62).

3. The LED chip assembly as claimed in claim 2, wherein the second insulating layer (42) is a rectangular structure, when N = 1, three first conductive parts (61) and one second conductive part (62) being respectively located at four corners of the rectangular structure.

4. The LED chip assembly as claimed in claim 1, wherein
2N LED light-emitting units are provided, each of the LED light-emitting units being provided with three LED chips (20), 2N LED light-emitting units being arranged in pairs, two first electrodes (21) of two adjacent LED chips (20) being located between two second electrodes (22) in each pair of LED light-emitting units, N being a natural number and N ≥ 1,
wherein 6N first circuits (51) and 6N second circuits (52) are provided, 3N first conductive parts (61) being provided, two second conductive parts (62) being provided, first ends of the 6N first circuits (51) being respectively connected with first electrodes (21) of 6N LED chips (20) in one-to-one correspondence, second ends of two adjacent first circuits (51) being merged and connected with one first conductive part (61), first ends of the 6N second circuits (52) being respectively connected with second electrodes (22) of the 6N LED chips (20) in one-to-one correspondence, and second ends of the second circuits (52) of the LED light-emitting units located in a same column being merged and connected with one second conductive part (62).

5. The LED chip assembly as claimed in claim 1, wherein the transparent support layer (30) is a functional film, the functional film being one or more of a polarizing film, an anti-glare film and a high-transmittance film, wherein a light transmittance of the high-transmittance film is between 85% and 97%.

6. The LED chip assembly as claimed in claim 5, wherein the LED chip assembly further comprises an adhesive layer (70) connected between the functional film and the substrate layer (10).

7. The LED chip assembly as claimed in claim 1, wherein the first insulating layer (41) is provided with a first notch for accommodating the first circuit (51) and a second notch for accommodating the second circuit (52), the second insulating layer (42) being provided with a third notch for accommodating the first conductive part (61) and a fourth notch for accommodating the second conductive part (62).

8. The LED chip assembly as claimed in claim 1, wherein a thickness of the substrate layer (10) is less than or equal to a thickness of the LED chip (20).

9. A processing method of an LED chip assembly, for processing the LED chip assembly as claimed in any one of claims 1-8, the processing method comprising following steps:
obtaining the transparent support layer (30);
fixing the LED light-emitting unit to the transparent support layer (30) and enabling the light-emitting surface (23) of the LED chip (20) of the LED light-emitting unit to face the transparent support layer (30);
arranging the substrate layer (10) around the LED light-emitting unit, and exposing the first electrode (21) and the second electrode (22) of the LED chip (20) from a surface, away from the transparent support layer (30), of the substrate layer (10);
covering the first insulating layer (41) on the surface, away from the transparent support layer (30), of the substrate layer (10), and arranging the first circuit (51) connected with the first electrode (21) and the second circuit (52) connected with the second electrode (22) in the first insulating layer (41), wherein the first circuit (51) and the second circuit (52) both expose from a surface, away from the substrate layer (10), of the first insulating layer (41); and
covering the second insulating layer (42) on the surface, away from the substrate layer (10), of the first insulating layer (41), and arranging the first conductive part (61) connected with the first electrode (21) and the second conductive part (62) connected with the second circuit (52) in the second insulating layer (42), wherein the first conductive part (61) and the second conductive part (62) both expose from a surface, away from the first insulating layer (41), of the second insulating layer (42).

10. The processing method as claimed in claim 9, after a step of obtaining the transparent support layer (30), the processing method further comprising: covering a surface of the transparent support layer (30) with an adhesive layer (70).

11. The processing method as claimed in claim 9, wherein a step of fixing the LED light-emitting unit to the transparent support layer (30) and enabling the light-emitting surface (23) of the LED chip (20) of the LED light-emitting unit to face the transparent support layer (30) comprises: stacking a temporary substrate provided with the LED light-emitting unit together with the transparent support layer (30) to fix the LED light-emitting unit to a surface, facing the temporary substrate, of the transparent support layer (30), and removing the temporary substrate.

12. An LED display apparatus, comprising one or more LED chip assemblies, wherein the LED chip assembly is the LED chip assembly as claimed in any one of claims 1-8.
